# EUROPEAN PATENT APPLICATION

(11) **EP 1 956 432 A1**
(43) Date of publication of application: **13.08.2008**
(21) Application number: 07002958.2
(22) Date of filing: 12.02.2007
(51) Int. Cl.: G03F 7/20, G03F 7/38, G03F 7/16

(54) **Methods and systems for improved immersion lithographic processing**

(71) Applicant: Interuniversitair Microelektronica Centrum, 3001 Leuven (BE); Intel Corporation, Santa Clara, CA 95052-8119 (US)
(72) Inventor: Kocsis, Michael, Santa Clara, CA 95054 (US); Gronheid, Roel, 3370 Boutersem (BE)
(74) Representative: Bird, William Edward

(57) **Abstract**

A method (300) and system (500) are described for immersion lithographic processing of a device (3), whereby for control of watermark defects on the device (3), a predetermined rinse is performed. The method comprises obtaining a device (3) comprising a resist layer (4) and rinsing a surface of the device (3), prior and/or after exposure with an acidic rinse fluid. The invention furthermore relates to an acidic rinse fluid and to the use thereof in lithographic processing.

## Description

### Technical field of the invention

The present invention relates to the field of processing of electronic devices, e.g. in semiconductor processing. More particularly, the present invention relates to systems and methods for processing devices, e.g. immersion lithographic processing.

### Background of the invention

In the production of today's integrated circuits, optical lithography is one of the key techniques. The ongoing miniaturisation of integrated circuits or other devices results in a number of problems, which may be encountered during optical lithography. When, in an optical lithographic system, light generated by a light source is incident on a mask, the light will be diffracted. The smaller the dimensions of the structures on this mask, the more the light will spread. Hence, the smaller the dimensions of the structures on the mask, the less of this spread-out light will be collected by an objective lens so as to be focused onto a resist layer. As a result, the image of the mask structure formed onto the resist layer will be of a low quality. A well-known solution to cope with the light spreading and consequently to obtain sufficient quality of the mask image is the use of systems having a high numerical aperture (NA). Often immersion liquids are used to deal with the corresponding incidence of light having a high angle of incidence onto the wafer.

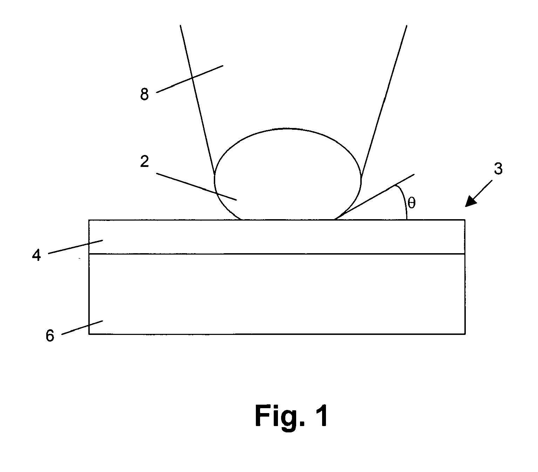

Implementing immersion lithography has given rise to a number of particular problems, for example associated with the use of an immersion liquid in contact with the resist layer used in the lithographic process. One of the problems arising is the presence of water mark defects on the lithographic processed devices. Water mark defects occur when water droplets, e.g. released by the nozzle of an immersion hood, remain on the device to be processed, dry on the surface and leave a residue of dissolved components. It is unclear what the role of residue of dissolved components is with respect to watermark formation. Water drops are left on the surface especially when the receding contact angle between the immersion liquid and the substrate surface is too small.. The receding contact angle θ between the immersion liquid 2 and the resist or resist stack 4 on the substrate 6 of the device 3 is shown in Fig. 1. Furthermore, the immersion hood 8 also is illustrated. Water drops remaining on the substrate surface can affect the development process, resulting in bridging or T-topping defects occurring in circular patterns. Water mark defects typically have a diameter in the range of 1 µm to 5 µm, thus resulting in a high kill ratio. The occurrence of a water mark defect therefore often results in a non-useful die on the substrate.

One known technique for reducing or preventing water mark defects is the increase of the receding contact angle between the immersion hood and the resist. The receding contact angle can be altered e.g. by adjusting the hydrophobic character of the surface of the resist or top layer thereon, by adjusting the scanning speed, the type of showerhead, etc. An alternative method for reducing or preventing watermarks is the use of topcoats that are not porous to water, but all topcoats seem to be at least somewhat water permeable. The effect of rinsing on water mark defects also has been studied. The above solutions introduce limitations for the resist or resist stacks used, e.g. with respect to their wettability, and/or to the lithographic system used, e.g. with respect to the shape and scanning speed of the immersion hood.

The effect of rinsing on the formation and occurrence of watermark defects also has been studied. In Proceedings of SPIE **6153** (2006), Carcasi et al. discuss the effect of rinsing on different types of resists and top coats. It was seen that a correlation occurred between pre-rinsing and water uptake for certain top coats. Furthermore, it was concluded that pre-exposure rinsing as well as post-exposure rinsing both allow elimination of certain defects.

### Summary of the invention

It is an object of the present invention to provide good apparatus or methods for immersion lithographic processing. It is an advantage of embodiments of the present invention that devices by immersion lithographic processing can be obtained with a low number or even no watermark defects. It furthermore is an advantage of embodiments of the present invention that systems and methods for immersion lithographic processing can be obtained wherein only a limited influence on the efficiency of the lithographic processing occurs, i.e. where there is e.g. no or a reduced need for slower scanning. As an additional advantage, this puts less constraints on resist design, since watermarks can be prevented by the post-processing and there is no need for high contact angle or low intrinsic watermark formation. It also is an advantage of embodiments of the present invention that the measures taken for controlling the occurrence, the quantitative and/or the qualitative aspects of watermark defects can be controlled easily. It is an advantage of embodiments of the present invention that the measures taken for controlling the occurrence, the quantitative aspects and/or the qualitative aspects of watermark defects can be performed before or after the exposure, i.e. outside the exposure time frame.

The above objective is accomplished by a method and device according to the present invention.

The present invention relates to a method for immersion lithographic processing of a device comprising a resist layer, the method comprising rinsing a surface of said device with an acidic rinse fluid. It is an advantage of embodiments of the present invention that watermark defect formation can be controlled, e.g. that the number of watermark defects can be reduced compared to immersion lithographic processing without rinsing using acidic rinse fluid. It also is an advantage of embodiments of the present invention that little changes are required to the device for reducing or avoiding watermark defects. It furthermore is an advantage of embodiments of the present invention that efficient, e.g. time efficient, methods are provided for immersion lithographic processing with control of watermark defects, e.g. not placing a large burden on the lithographic processing speed.

The method may furthermore comprise exposing the resist layer according to a predetermined pattern, the rinsing being rinsing prior and/or after said exposing. It is an advantage of the present invention that rinsing may be either performed prior exposing or after exposing.

Rinsing a surface of the device with an acidic rinse fluid may comprise rinsing a surface of the device with a rinse fluid comprising an acid component.

Rinsing a surface of the device with an acidic rinse fluid may comprise rinsing a surface of the device with a rinse fluid comprising an acid component within a range having a minimum concentration larger than 0 mol percentage and a maximum concentration such that resist lines obtained through said lithographic processing are substantially not dissolved.

Resist lines obtained through said lithographic processing being substantially not dissolved may comprise that dissolving of resist material is resulting in less than 50% of the height of the resist lines being removed.

The acidic rinse fluid may comprise an acid component with a concentration between 10⁻⁵ mol percentage and 10⁻² mol percentage.

The acid component concentration may be in the range between 10⁻⁴ mol percentage and 5.10⁻² mol percentage.

The rinsing step may be adapted to leave the surface topology invariant. The rinsing step may be performed before developing the resist layer.

The acidic rinse fluid may comprise a fluorine based acid.

The fluorine based acid may comprise any of a fluorine based sulfonic acid or a fluorine based acetic acid.

Providing an acid component may comprise providing trifluoromethanesulfonic acid or an acid halide, anhydride or ester derivative thereof.

The acidic rinse fluid may comprise an acid component in molecular form.

The acidic rinse fluid may comprise an acid component that is mobile in a top layer covering the resist layer.

The method furthermore may comprises, after said rinsing with an acidic rinse fluid, rinsing the surface of the device with a non-acidic rinse fluid.

The non-acidic rinse fluid may be a non-intentionally acid component doped rinse fluid, such as e.g. but not limited to de-ionised water.

The present invention also relates to a rinse fluid for use in immersion lithographic processing of a device, the rinse fluid being an acidic rinse fluid comprising an acid component within a range having a minimum concentration larger than 0 mol percentage and a maximum concentration such that resist lines obtained through said lithographic processing are substantially not dissolved.

The acidic rinse fluid may comprise an acid component with a concentration between 10⁻⁵ mol percentage and 10⁻² mol percentage.

The present invention furthermore relates to the use of a rinse fluid as described above for rinsing a device comprising a resist layer in immersion lithographic processing. Such a use may be a use for controlling watermark defects on the device. Controlling watermark defects may comprise reducing watermark defects, e.g. compared to a similar or the same immersion lithographic process wherein only rinsing with a non-acidic rinse fluid is performed, i.e. wherein no rinsing with an acidic rinse fluid is performed.

The present invention also relates to a lithographic processing system, the system comprising an acidic rinse fluid providing means for providing an acidic rinse fluid for rinsing the surface of a device comprising a resist layer in immersion lithographic processing.

The present invention furthermore relates to the use of an immersion lithographic processing system comprising a rinse fluid providing means for rinsing a surface of a device comprising a resist layer using an acidic rinse fluid.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The teachings of the present invention permit the design of improved methods and apparatus for immersion lithographic processing and consequently in the devices derived there from.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 illustrates the receding contact angle between an immersion liquid droplet and a substrate surface, as typically present in an immersion lithographic processing system known from prior art.
Fig. 2 illustrates an exemplary immersion lithographic processing system as can be used in a method according to embodiments of the present invention.
Fig. 3 illustrates an exemplary method for immersion lithographic processing according to an embodiment of the first aspect of the present invention.
Fig. 4 illustrates an exemplary immersion lithographic processing system comprising an acidic rinse fluid providing means according to an embodiment of the third aspect of the present invention.
Fig. 5a to Fig. 5e indicate the presence of watermark defects for droplets dispensed on a surface and removed after 2 minutes (a), 3 minutes (b), 4 minutes (c), 5 minutes (d) and 6 minutes (e) respectively using a non-acidic rinse for a first type of resist according to an example of a conventional lithographic processing method.
Fig. 6a to Fig. 6e indicate the presence of watermark defects for droplets dispensed on a surface and removed after 2 minutes (a), 3 minutes (b), 4 minutes (c), 5 minutes (d) and 6 minutes (e) respectively using an acidic rinse fluid for a first type of resist according to an example of an embodiment of a method according to the present invention.
Fig. 7a to Fig. 7c indicate the presence of watermark defects for droplets dispensed on a surface and removed after 4 minutes (a), 5 minutes (b) and 6 minutes (c) respectively using a non-acidic rinse for a second type of resist according to an example of a conventional lithographic processing method.
Fig. 8a to Fig. 8c indicate the presence of watermark defects for droplets dispensed on a surface and removed after 4 minutes (a), 5 minutes (b) and 6 minutes (c) respectively using an acidic rinse fluid for a second type of resist according to an example of an embodiment of a method according to the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention. The terms first, second, third and the like in the description and in the claims, are used for distinguishing between similar elements and not necessarily for describing a temporal, spatial or ranking sequence. The terms top, bottom, over, under and the like in the description and the claims are used for descriptive purposes and not necessarily for describing relative positions. It is to be noticed that the term "comprising", used in the claims, should not be interpreted as being restricted to the means listed thereafter; it does not exclude other elements or steps. It does not preclude the presence or addition of one or more other features, integers, steps or components, or groups thereof. Thus, the scope of the expression "a device comprising means A and B" should not be limited to devices consisting only of components A and B.

Reference throughout this specification to "one embodiment" or "an embodiment" means that a particular feature, structure or characteristic described in connection with the embodiment is included in at least one embodiment of the present invention. The particular features, structures or characteristics may be combined in any suitable manner, as would be apparent to one of ordinary skill in the art from this disclosure, in one or more embodiments. The claims following the detailed description are hereby expressly incorporated into this detailed description, with each claim standing on its own as a separate embodiment of this invention. In the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention. With standard rinsing fluid there is meant rinsing fluid that is non-intentionally doped with acid components or acids. An often used standard rinsing fluid e.g. is de-ionised water, the invention not being limited thereto. With an acidic rinsing fluid, there is meant a rinsing fluid that is intentionally doped with acid components or acids. For example, the acidic rinsing fluid may by de-ionised water intentionally doped with acid components or acids.

In embodiments of the present application, the term "substrate" may include not only the basic carrier material but also materials to be processed and typical materials applied for performing a lithographic processing step, such as for example - but not limited to - a bottom anti-reflective coating. The term "substrate" furthermore also may include other materials, such as e.g. other materials used in semiconductor processing. The basic carrier material may be for example doped or undoped silicon, silicon-on-insulator substrate (SOI), gallium arsenide (GaAs), gallium arsenide phosphide (GaAsP), indium phosphide (InP), germanium (Ge), or silicon germanium (SiGe), glass or quartz substrates. The term "contact" may refer both to direct contact, i.e. one object being adjacent to a second object without material being in between both objects, and to indirect contact, whereby one object is coupled to another object by means of other solid or liquid material, for example intermediate layers being present between the two objects or a liquid drop being present between the two objects. The term "resist stack" may refer to the combination of a resist layer and a bottom coating, i.e. a coating between the resist layer and the substrate, which optionally may be a bottom anti-reflective coating (BARC). Optionally, also a top coating may be present, e.g. being a protective coating or being a top anti-reflective coating (TARC). In the present application, top coating and top layer are used for referring to the same item.

Where in the present application reference is made to "light" or "radiation", electromagnetic radiation typically used in immersion lithographic systems is referred to. In present application, often electromagnetic radiation having a wavelength of 193nm is used, but the invention is not limited thereto and other wavelengths in the ultraviolet and/or far or deep ultraviolet range or even other types of electromagnetic radiation may be used.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

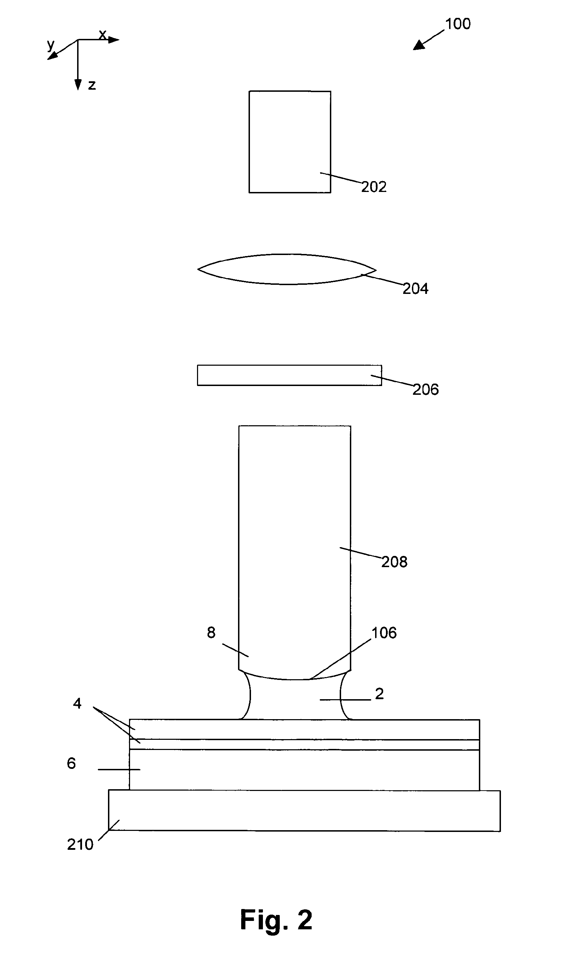

The embodiments of the present invention may be related to an immersion lithographic processing system. The method is applicable to lithographic processing which can be performed on any type of immersion lithographic set-up, such as but not limited to the set-up shown in Fig. 2, shown by way of illustration only. An optical lithographic system with a transmission set-up is shown, although the invention is not limited thereto and is e.g. also applicable to a system with a reflection set-up. It may be e.g. an immersion lithographic stepper system or an immersion lithographic scanner system. The optical immersion lithographic system 100 may comprise a source of electromagnetic radiation, e.g. an irradiation source 202. The radiation from the irradiation source 202 is, for example, transmitted through an optical system 204 comprising an optical diffraction device such as a lens and is incident on a mask 206. The mask 206 contains information about the image to be generated in a resist layer or resist stack 4 and is basically defined thereby. Optionally, the mask 206 may be part of a set of masks used for creating a device or circuit using lithography. Different types of masks exist; such as e.g. an alternated phase shift mask, an attenuated phase shift mask, a binary mask, etc. The light, carrying the mask information, is then passed through an imaging module 208, which e.g. may have a final lens surface 106, and thus is guided to a resist layer or resist stack 4 on a substrate 6. The optics of the imaging module 208 inherently defines the numerical aperture (N.A.) of the imaging module 208. The device 102 is optionally mounted on a substrate stage 210. Optionally, an immersion showerhead 8, also referred to as immersion hood 8, provides an immersion liquid 2 between the resist layer or resist stack 4 and the output of the imaging module 208, e.g. the final lens surface 106, in order to allow increase of the numerical aperture of the system 100. Other optional and/or additional components are not illustrated in Fig. 2. The system shown is only shown by way of illustration. For example, alternative systems that could be used are systems operating with micro-mirrors, e.g. systems used as optical mask writers.

In a first aspect, the present invention relates to a method for lithographic processing of a device. The method comprises obtaining a device 3 with a resist layer 4 or resist stack. The device 3 may comprise a substrate 6 whereon the resist layer 4 or resist stack is deposited. The substrate 6 may be any type of substrate used for producing e.g. a semiconductor device, as described above. The resist material used may be positive or negative resist and/or chemically amplified resist. Preferably the resist layer 4 or resist stack comprises resist suitable for immersion lithography, such as for example, but not limited to, Sumitomo PAR-IM850 resist as obtainable from Sumitomo Corporation. If a resist stack is present, besides a resist layer 4 also a bottom anti-reflective coating and/or a top anti-reflective coating or a top protective coating may be present. In the device 3, the resist layer 4 thus may be covered with one or more layers. Obtaining a device 3 may comprise providing a device 3 by coating a substrate 6 with a resist layer 4. Such coating may be done in any suitable way, such as e.g. spin coating, dip coating, etc. the invention not being limited thereto. Obtaining a device 3 also may comprise obtaining a previously made device comprising a resist layer.

The method also comprises rinsing the surface of the device 3 with an acidic rinse fluid. Such rinsing may be a pre-exposure rinse, i.e. prior to illumination of the device and/or a post-exposure rinse, i.e. after illumination of the device. The rinsing may be performed outside a time-span determined by the illumination of the device 3. Rinsing thereby may be understood as cleansing a surface with a fluid, e.g. a liquid. The fluid used for rinsing in the present application is referred to as a rinse fluid. It is to be noticed that rinsing leaves the surface of the device 3 morphologically and topologically invariant, i.e. the surface of the device 3 is structurally left invariant. It thus is to be noted that rinsing is done on a wafer whereby no developing of the resist has already occurred, or in other words rinsing is performed prior to a developing step. Rinsing thus is performed on an non-patterned device whereby, for post exposure rinse, only a latent image is present. The surface of the device rinsed may be the surface closest to the resist layer 4, i.e. the surface of the resist layer 4, the surface of a top layer covering the resist layer 4, and not the surface of the device positioned at the opposite side of the resist layer 4 with respect to the substrate 6. According to embodiments of the present invention, the rinsing is performed using an acidic rinse fluid. Such an acidic rinse fluid may be a rinse fluid comprising an acid component. The acid component may be present in a concentration within a range having a minimum concentration larger than 0 mol percentage and a maximum concentration defined such that the resist lines obtained through the lithographic processing are substantially not dissolved, i.e. substantially undissolved. The concentration resulting in the resist lines not being substantially dissolved in the development step may depend on the type of resist used. The concentration may be such that less than 50%, preferably less than 20% more preferably less than 10%, even more preferably less than 1 % of the resist lines is dissolved, i.e. the less the material of the resist lines is dissolved, the better. The concentration being sufficiently small may be such that less than 50%, preferably less than 20%, more preferably less than 10%, even more preferably less than 1% of the height of the resist is removed after development. This may be determined in combination with a given set of predetermined lithographic processing parameters, e.g. for a predetermined exposure length and a predetermined dose. The lower limit for the concentration of acid component is that it should be larger than 0%. The preferred limits for the concentration of the acid component used may depend on the type of acid component and the type of photoresist used. The preferred concentration range may be between 10⁻⁵ mol percentage and 10⁻² mol percentage, e.g. between 10⁻⁴ mol percentage and 10⁻² mol percentage, e.g. between 10⁻⁴ mol percentage and 5.10⁻² mol percentage. In particular examples, the concentration ranges used may be between 10⁻³ mol percentage and 10⁻² mol percentage, the invention not being limited thereto. The acid components preferably are not in polymeric form and preferably are in molecular form. In other words, the acid components preferably are in such a form that they are mobile in the resist layer, i.e. that they are not immobilised. In this way the acid components can e.g. counterbalance acid depletion. Possible rinse fluids, e.g. rinse liquids may for example be a mixture of standard rinse liquid, such as e.g. de-ionised water, with an acid component. Such an acid component may e.g. be a fluorine based acid, such as for example a fluorine based sulfonic acid or a fluorine based acetic acid. An example thereof may be trifluoromethanesulfonic acid or an acid halide, anhydride or ester derivate thereof. Optionally, only sulphonic acids may be used. Furthermore also photochemical precursors to such acids may be used. Furthermore most very strong inorganic acids are also of interest such as sulphuric acid, phosphoric acid, HBF₄, HSbF₆, ... Another particular example of an acid that may be used is a non-afluorobutanesulphonic acid, also known as nonaflic acid.

The rinsing step with the acidic rinse fluid according to embodiments of the present invention results in a reduction or no watermark defects being present in the device 4. Reduction of watermark defects may be a reduction of the number of watermark defects and/or a reduction of the size and/or intensity of the watermark defects.

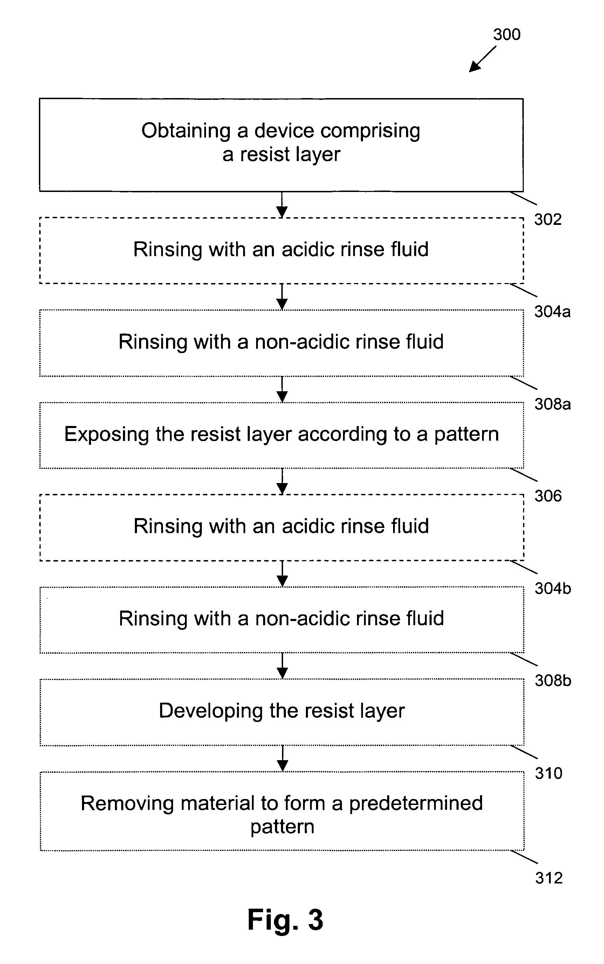

A schematic representation of an exemplary method 300 according to the present aspect is shown in Fig. 3, indicating different standard and optional steps for a method of immersion lithographic processing of a device. The steps of obtaining 302 a device comprising a resist layer 4 and rinsing 304a, 304b the surface with an acidic rinse fluid are illustrated, as described above.

The method 300 furthermore preferably comprises a step of exposing 306 the resist layer 4 according to a predetermined pattern. The latter may preferably be performed by exposing according to a pattern via a mask, although the invention is not limited thereto and e.g. direct writing a pattern with a beam also may be performed. The exposing 306 may be performed using a preferred irradiation source. An example thereof may be an irradiation source providing 193nm radiation, such as for example an ArF excimer laser. The exposure thereby is done through an immersion fluid in order to comply with high numerical aperture applications. The exposing 306 may be done after the rinsing 304a, prior to the rinsing 304b or in between two rinsing steps with acidic rinse fluid. Embodiments of the present invention also may relate to a method of semiconductor processing of a device whereon immersion lithography is to be applied, whereby the rinsing step is performed during preparation of the device, without being immediately followed by an exposure step. The devices thus may be prepared for use in immersion lithographic processing of a device.

In a preferred embodiment, after the rinsing 304a, 304b with acidic rinse fluid, rinsing 308a, 308b with a non-acidic rinse fluid, i.e. for example a conventional rinse fluid such as e.g. de-ionised water, may be performed. A non-acidic rinse fluid is a non-intentionally acid component doped rinse fluid. Such rinsing 308a, 308b may be performed immediately after rinsing 304a, 304b with acidic fluid and therefore may be performed either only prior to exposure, after exposure or both prior and after exposure, immediately after rinsing 304a, 304b with acidic fluid. Furthermore, optionally an additional rinse with a non-acidic fluid also may be performed before or after exposing 306, e.g. prior to the exposing 306 if rinsing with acidic rinse fluid is performed after exposing 306, after exposing 306 if rinsing with acidic rinse fluid is performed prior to exposing, the invention not being limited thereto.

The method furthermore may comprise other steps such as e.g. a developing step 310 which preferably is used for obtaining a different structure for irradiated parts of the resist layer and non-irradiated parts of the resist layer. Furthermore one or more baking steps may be performed. The method preferably also comprises a removing step 312, i.e. for performing a selective removal of material of the resist layer. Depending on whether positive or negative resist is used, removal of the irradiated or non-irradiated parts of the resist will be performed. Selective removing may e.g. be done by etching the device, thereby structurally altering the device according to a predetermined pattern. Additional steps of removing a top anti-reflective coating, if present, providing a baking step, etc. also may be performed and are known in the art.

Each of the above steps may be performed in an automatic and/or automated way. Such steps may be implemented by a computerised means for carrying out the function, e.g. by a processor of such a computer system. Thus a processor with the necessary instructions for carrying out such a method or a step thereof forms a means for carrying out the method or a step thereof in an automated way.

It is an advantage of embodiments according to the present invention that the provided acid component will counter-balance the acid depletion from the resist during lithographic processing. The obtained pattern may be used in a number of applications, such as e.g. depositing material in a predetermined pattern, removing material in a predetermined pattern, doping material in a predetermined pattern, treating material according to a predetermined pattern, etc.

In a second aspect, the present invention relates to a rinse fluid for use in immersion lithographic processing of a device and to the actual used thereof for immersion lithographic processing of a device. According to embodiments of the present aspect, the rinse fluid is an acidic rinse fluid comprising an acid component within a concentration within a range having a minimum level larger than 0 mol percentage and a maximum concentration such that resist lines obtained through the lithographic processing are substantially not dissolved. The concentration resulting in the resist lines not being substantially dissolved may depend on the type of resist used. The concentration may be such that less than 50%, preferably less than 20% more preferably less than 10%, even more preferably less than 1% of the resist lines is dissolved, i.e. the less the material of the resist lines is dissolved, the better. The concentration being sufficiently small may be such that less than 50%, preferably less than 20%, more preferably less than 10%, even more preferably less than 1% of the height of the resist is removed. This may be determined in combination with a given set of predetermined lithographic processing parameters, e.g. for a predetermined exposure length and a predetermined dose. The lower limit for the concentration of acid component is that it should be larger than 0%. The preferred limits for the concentration of the acid component used may depend on the type of acid component used. The preferred concentration range may be between 10⁻⁵ mol percentage and 10⁻² mol percentage, e.g. between 10⁻⁴ mol percentage and 10⁻² mol percentage, e.g. between 10⁻⁴ mol percentage and 5.10⁻² mol percentage. In particular examples, the concentration ranges used may be between 10⁻³ mol percentage and 10⁻² mol percentage, the invention not being limited thereto. The acid components preferably are not in polymeric form and preferably are in molecular form. In other words, the acid components preferably are in such a form that they are mobile in the resist layer, i.e. that they are not immobilised. In this way the acid components can e.g. counterbalance acid depletion. Possible rinse fluids, e.g. rinse liquids may for example be a mixture of standard rinse liquid, such as e.g. de-ionised water, with an acid component. Such an acid component may e.g. be a fluorine based acid, such as for example a fluorine based sulfonic acid or a fluorine based acetic acid. An example thereof may be trifluoromethanesulfonic acid or an acid halide, anhydride or ester derivate thereof. Optionally, only sulphonic acids may be used. Furthermore also photochemical precursors to such acids may be used.

Furthermore most very strong inorganic acids are of interest such as sulphuric acid, phosphoric acid, HBF₄, HSbF₆, ... Another particular example of an acid that may be used is a non afluorobutanesulphonic acid, also known as nonaflic acid. The acidic rinse fluid is suitable for rinsing a device comprising a resist layer in immersion lithographic processing. The acidic rinse fluid may be used in such immersion lithographic processing for reducing watermark defects, e.g. compared to conventional immersion lithographic processing wherein rinsing with a non-acidic rinse fluid is performed.

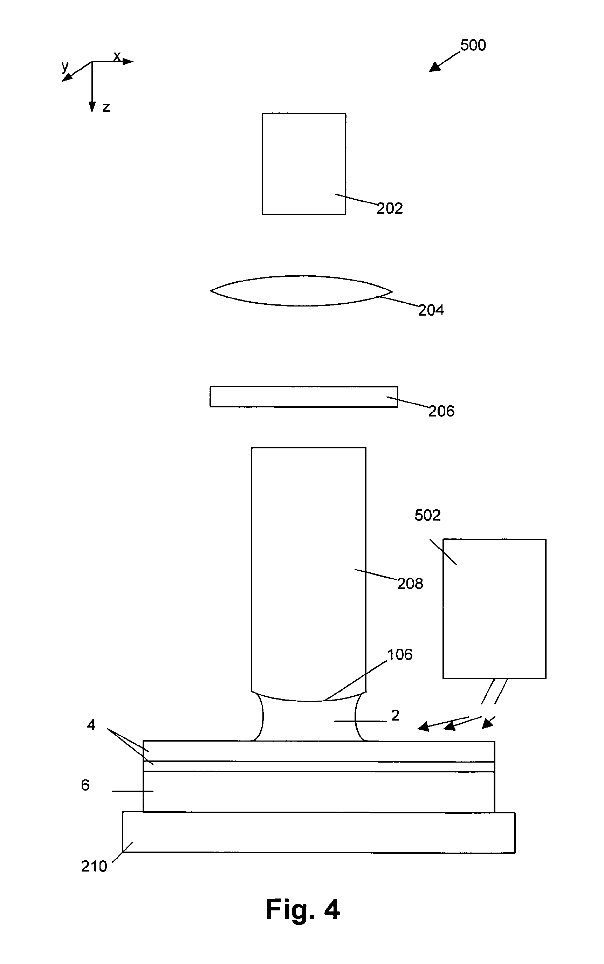

In a third aspect, the present invention relates to a lithographic processing system. The lithographic processing system may comprise an acidic rinse fluid providing means for providing an acidic rinse fluid for rinsing the surface of a device comprising a resist layer for immersion lithographic processing. Such a system 500 may e.g. be as described in Fig. 4, comprising standard components as provided in a conventional immersion lithographic system, an example thereof described above in relation to Fig. 2, but wherein a providing means 502 for providing acidic rinse fluid is introduced. The providing means may be a container with an output. The acid rinse fluid may be provided pre mixed. Alternatively, the acid rinse fluid may be mixed during use. The system, or more particularly the providing means, therefore may comprise a first container with a non-acid rinse fluid, e.g. water, a second container with the acid and a control system for controlling the addition of acidic components.

By way of illustration, the invention not being limited thereto, an example of a post exposure rinse using acidic rinsing fluid is discussed below. For two types of resists, a comparison is made between the effect of a post exposure rinse using a standard rinsing fluid, in the present case being de-ionised water, and a post exposure rinse using an acidic rinsing fluid, here being de-ionised water and triflic acid (CF₃SO₃H). The experiments were performed for two different types of resist, i.e. PAR-IM850 obtainable from Sumitomo Corporation and JAM-211 from Shin-Etsu Chemical Corporation.

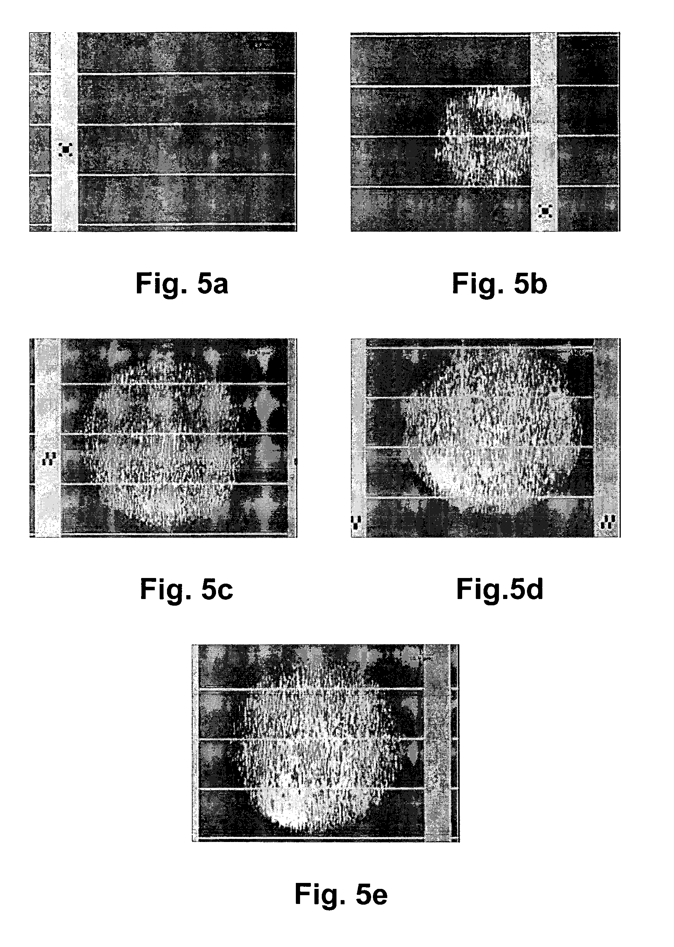

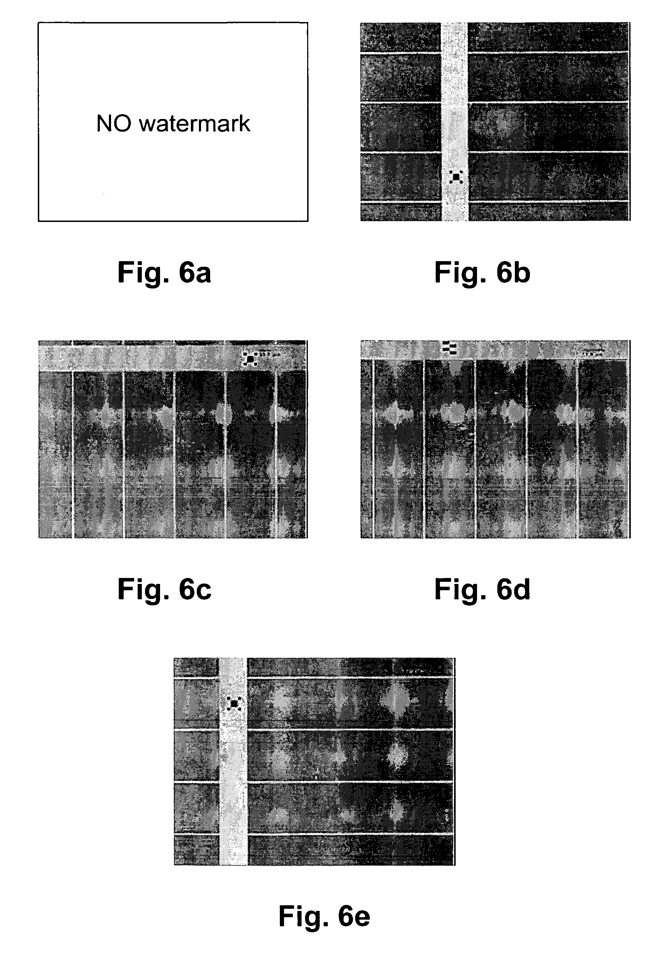

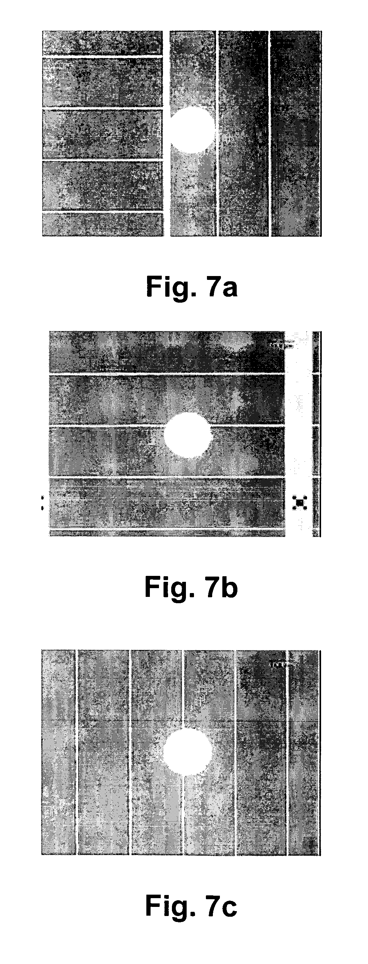

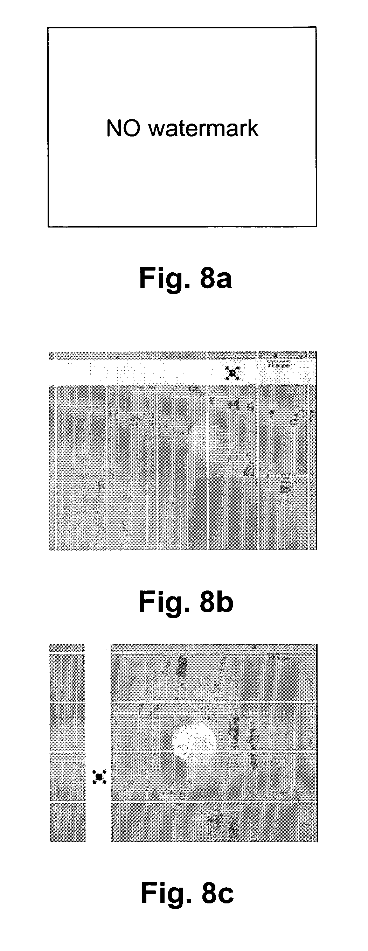

DI water droplets were dispensed on the resist surface and left there during a predetermined time span. Thereafter the surface was rinsed using either the standard rinsing fluid or a combination of an acidic rinsing fluid followed by use of the standard rinsing fluid. Fig. 5a to Fig. 5e illustrates the effects on watermarks observed with optical microscopy when a post exposure rinse with only standard rinsing fluid is performed for different queue times of the dispensed droplets on the surface of a PAR IM 850 resist. Fig. 6a to Fig. 6e illustrates the effects on watermarks observed with optical microscopy when a post exposure rinse with an acidic rinsing fluid is performed for 10s followed by a standard DI water rinse. The acidic rinsing fluid used is a 100ml puddle of water and triflic acid, the triflic acid being present in a concentration of 5.6 10⁻⁴ mol%. The queue times used, i.e. the time spans used before removing the droplets by a rinse, are 2 minutes (a), 3 minutes (b), 4 minutes (c), 5 minutes (d) and 6 minutes (e). From Fig. 5a to Fig. 6e it can be seen that the longer the queue times of the droplets on the surface of the resist, the stronger the watermark defects are present. Furthermore, comparison between the corresponding pictures of Fig. 5a to Fig. 5e and Fig. 6a to Fig. 6e indicates that watermarks are not present or significantly less pronounced when a rinse with an acidic rinse fluid is used, thus illustrating the advantages of the present invention. In a second experiment, wherein a different type of resist material is use, i.e. LS 24, a similar result can be seen. Fig 7a to Fig. 7c illustrates watermark defects observed for droplets with a queue time of 4 minutes (a), 5 minutes (b) and 6 minutes (c) respectively, whereby droplets were removed by a rinse using standard rinsing fluid. Fig. 8a to Fig. 8c illustrate the effects on watermark defects observed for droplets with a queue time of 4 minutes (a), 5 minutes (b) and 6 minutes (c) respectively, whereby droplets first are removed by a rinse using an acidic rinse fluid, followed by a rinse using standard rinsing fluid. The acidic rinse fluid for the present example is a puddle of water and triflic acid, the triflic acid being present in a concentration of 1.12 10⁻³ mol percentage. Watermark defects were observed using optical microscopy. When an acidic rinsing fluid was used, no or significantly less pronounced watermark defects can be distinguished compared to a rinse whereby only standard rinsing fluid is used. The latter again illustrates the advantages of embodiments of the present invention.

It is to be understood that although preferred embodiments, specific constructions and configurations, as well as materials, have been discussed herein for devices according to the present invention, various changes or modifications in form and detail may be made without departing from the scope and spirit of this invention. For example, steps may be added or deleted to methods described within the scope of the present invention.

## Claims

1. A method (300) for immersion lithographic processing of a device (3) comprising a resist layer (4), the method (300) comprising
- rinsing (304a, 304b) a surface of said device (3) with an acidic rinse fluid.

2. A method (300) according to claim 1, wherein the method (300) furthermore comprises
- exposing (306) the resist layer (4) according to a predetermined pattern,
said rinsing (304a, 304b) being rinsing prior and/or after said exposing (306).

3. A method (300) according to any of claims 1 to 2, wherein rinsing (304a, 304b) a surface of the device with an acidic rinse fluid comprises rinsing a surface of the device with a rinse fluid comprising an acid component.

4. A method (300) according to any of claims 1 to 3, wherein rinsing a surface of the device with an acidic rinse fluid comprises rinsing a surface of the device with a rinse fluid comprising an acid component within a range having a minimum concentration larger than 0 mol percentage and a maximum concentration such that resist lines obtained through said lithographic processing are substantially not dissolved.

5. A method (300) according to any of claims 1 to 4, wherein the acidic rinse fluid comprises an acid component with a concentration between 10⁻⁵ mol percentage and 10⁻² mol percentage.

6. A method according to any of the previous claims, wherein said rinsing step is adapted to leave the surface topology invariant.

7. A method (300) according to any previous claim, wherein said acidic rinse fluid comprises a fluorine based acid.

8. A method (300) according to claim 7, wherein said fluorine based acid comprises any of a fluorine based sulfonic acid or a fluorine based acetic acid.

9. A method (300) according to claim 7, wherein providing an acid component comprises providing trifluoromethanesulfonic acid or an acid halide, anhydride or ester derivative thereof.

10. A method (300) according to any of claims 1 to 9, wherein the acidic rinse fluid comprises an acid component in molecular form.

11. A method (300) according to any of claims 1 to 10, wherein the acidic rinse fluid comprises an acid component that is mobile in a top layer covering the resist layer.

12. A method (300) according to any of claims 1 to 11, wherein the method furthermore comprises, after said rinsing with an acidic rinse fluid, rinsing the surface of the device with a non-acidic rinse fluid.

13. A rinse fluid for use in immersion lithographic processing of a device, the rinse fluid being an acidic rinse fluid comprising an acid component within a range having a minimum concentration larger than 0 mol percentage and a maximum concentration such that resist lines obtained through said lithographic processing are substantially not dissolved.

14. A rinse fluid according to claim 13, wherein the acidic rinse fluid comprises an acid component with a concentration between 10⁻⁵ mol percentage and 10⁻² mol percentage.

15. Use of a rinse fluid according to any of claims 13 to 14 for rinsing a device comprising a resist layer in immersion lithographic processing.

16. Use according to claim 15 for controlling watermark defects on the device.

17. A lithographic processing system (500), the system (500) comprising an acidic rinse fluid providing means (502) for providing an acidic rinse fluid for rinsing the surface of a device comprising a resist layer in immersion lithographic processing.

18. Use of an immersion lithographic processing system (500) comprising a rinse fluid providing means (502) for rinsing a surface of a device comprising a resist layer using an acidic rinse fluid.
